Europäisches Patentamt

European Patent Office

Office européen des brevets

(11) Publication number : **0 642 861 A1**

## (12) EUROPEAN PATENT APPLICATION

(21) Application number : **94306481.6**

(22) Date of filing : **02.09.94**

(51) Int. Cl.⁶ : **B23B 35/00, H05K 3/00**

(30) Priority : **10.09.93 JP 226034/93**

(43) Date of publication of application :
**15.03.95 Bulletin 95/11**

(84) Designated Contracting States :
**DE FR GB**

(71) Applicant : **International Business Machines
Corporation
Old Orchard Road
Armonk, N.Y. 10504 (US)**

(72) Inventor : **Misono, Shinji
3-10-5 201, Kamikitazawa
Setagaya-ku, Tokyo (JP)**
Inventor : **Tezuka, Shu
33-13-201, Tanacho,
Midori-ku
Yokohama-shi, Kanagawa-ken (JP)**
Inventor : **Iwano, Kazuo
2-1-7, Ekoda, Midori-ku
Yokohama-shi, Kanagawa-ken (JP)**

(74) Representative : **Burt, Roger James, Dr.
IBM United Kingdom Limited
Intellectual Property Department
Hursley Park
Winchester Hampshire SO21 2JN (GB)**

(54) **Apparatus and method for drilling.**

(57)    The positions of holes to be drilled along a
line in a printed circuit board is described in
binary vectors. The order of drilling is also
described in binary vectors. The former binary
vectors are made to correspond to the latter
binary vectors through a conversion matrix
where every partial matrix is normal. The posi-
tions of the holes are determined from the
drilling order, or the drilling order is determined
from the positions of the holes by the corres-
pondence.

FIG. 7

EP 0 642 861 A1

Field of the invention

The present invention relates to a drill apparatus for making holes in printed circuit boards, steel plates, plastic plates, and other plate materials. More specifically, the present invention relates to optimizing the drilling of many holes along a predetermined line.

Prior Art

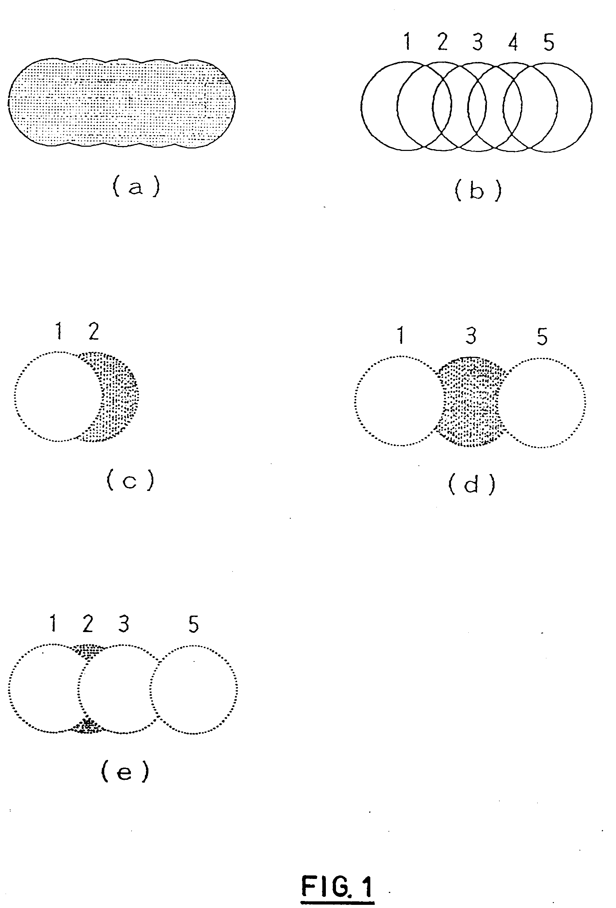

In processing printed circuit boards and other materials, a series of circular holes is often formed in such a way that their combination produces a linear long and narrow hole. For example, this method is used to make a hole in a printed circuit board for placing a chip. Figure 1 shows this type or processing, wherein five round holes are formed continuously as shown in (b) thus to form a linear long and narrow hole as shown in (a). When the holes are made from 1 to 5 successively in the case of Figure 1, a hole on the left side is already drilled at the time of drilling of holes 2, 3, 4, and 5, so that the stress applied to the drill screw differs between the left and right side, making for a considerable probability of screw breakage. Since exchanging the drill screw requires time much larger than the time for horizontal motion, it is desirable to keep screw damage to the lowest extent possible. Thus, the drilling order must be determined so that the drill screw receives uniform stress at the left and right sides as much as possible. For example, drilling in the order of 1, 5, 3, 2 and 4 as shown in (d) and (e) in the example of Figure 1 is satisfactory. Determination of the drilling order so that uniform stress is applied at the left and right sides is called step drilling.

Conventional step drilling, however, has been determined manually for the drilling order based on experience, causing a bottleneck due to increased working hours for the design of the drilling steps.

The present invention has been made in view of the above mentioned circumstances and has the object of automatic determination of the order of drilling in step drilling.

Summary of Invention

In order to attain the above object, the present invention comprises describing in a binary vector fashion the positions of holes arranged along a line; as well as describing in a binary vector fashion the order of holes to be made; and making these binary vectors correspond by a conversion matrix in which every partial matrix is regular. On the basis of the correspondence, the hole position is determined by the drilling order, or the drilling order is determined by the hole position.

An exemplary case where N holes are made along a straight line is discussed below. Numbering is made from 1 through N for the holes to be made from one end of the line to the other end of the line; the hole number drilled at the i-th step is to be expressed by D [i] (1 < = i < = N). In the present invention, the hole number D [i] is determined by the drilling order i through a conversion matrix T. That is, vector v, which consists of the binary representation of the hole number D[i], is determined by the product of the conversion matrix T and the vector u consisting of the binary representation of the order i.

$$
\begin{pmatrix} v[1] \\ v[2] \\ \cdot \\ \cdot \\ \cdot \end{pmatrix} = \begin{bmatrix} \ T \ \end{bmatrix} \begin{pmatrix} u[1] \\ u[2] \\ \cdot \\ \cdot \\ \cdot \end{pmatrix}
\tag{1}
$$

where v[1] (first element of the column vector) in the binary representation denotes the top bit of vector v, u[1] (first element of the column vector) in the binary representation denotes the top bit of vector u; v[2] and u[2] denote the second bit from the top in respective binary representations; and the other bits are represented in a similar way.

However, the conversion matrix T should satisfy the following condition:

every partial matrix $T_l$ of the conversion matrix T should be regular. Here, the partial matrix $T_l$ is defined as:

$$T_1 = (t_{ij} \mid 1 \leq i, j \leq l),\ \leq l \leq K \tag{2}$$

A matrix satisfying such condition, for example, when k = 4, is:

$$T = \begin{bmatrix} 1000 \\ 0100 \\ 0010 \\ 0001 \end{bmatrix} \quad (3)$$

The partial matrices $T_l$, l = 1, 2, 3 are each shown below and found to satisfy the condition.

$$T_1 = (1)$$

$$T_2 = \begin{bmatrix} 10 \\ 01 \end{bmatrix}$$

$$T_3 = \begin{bmatrix} 100 \\ 010 \\ 001 \end{bmatrix} \quad (4)$$

As another example, the following conversion matrix T is possible:

$$T' = \begin{bmatrix} 1111 \\ 0111 \\ 0011 \\ 0001 \end{bmatrix} \quad (5)$$

In this case also, the partial matrices $T_l$, l = 1, 2, 3 are each shown below and found to satisfy the condition set out above.

$$T_1 = (1)$$

$$T_2 = \begin{bmatrix} 11 \\ 01 \end{bmatrix}$$

$$T_3 = \begin{bmatrix} 111 \\ 011 \\ 001 \end{bmatrix} \quad (6)$$

According to the present invention, the hole number may be derived from the drilling order, or inversely the drilling order may be derived from the hole number. In either case, the correspondence between the drilling order and the hole number guides the drilling.

The invention is based on the following theorem which shows that the drilling order is uniformly distributed without bias.

Theorem: When a partial matrix $T_l$ of matrix T is regular and (u[1], u[2], ---, u[l]) repeats all the patterns in a $2^l$ cycle, (v[1], v[2], ---, v[k]) also repeats all the patterns in a $2^l$ cycle.

Proof: From the above mentioned condition, a partial matrix $T_l$ is regular for every 1. Then, (v[1], v[2], ---, v[l]) repeats all the patterns in a $2^l$ cycle. That is, v[1] (top bit) always represents 0 and 1 in alternation (for example, 010110), and v[1]v[2] (top 2 bits) represent 00, 01, 10, 11 one time each in every four times.

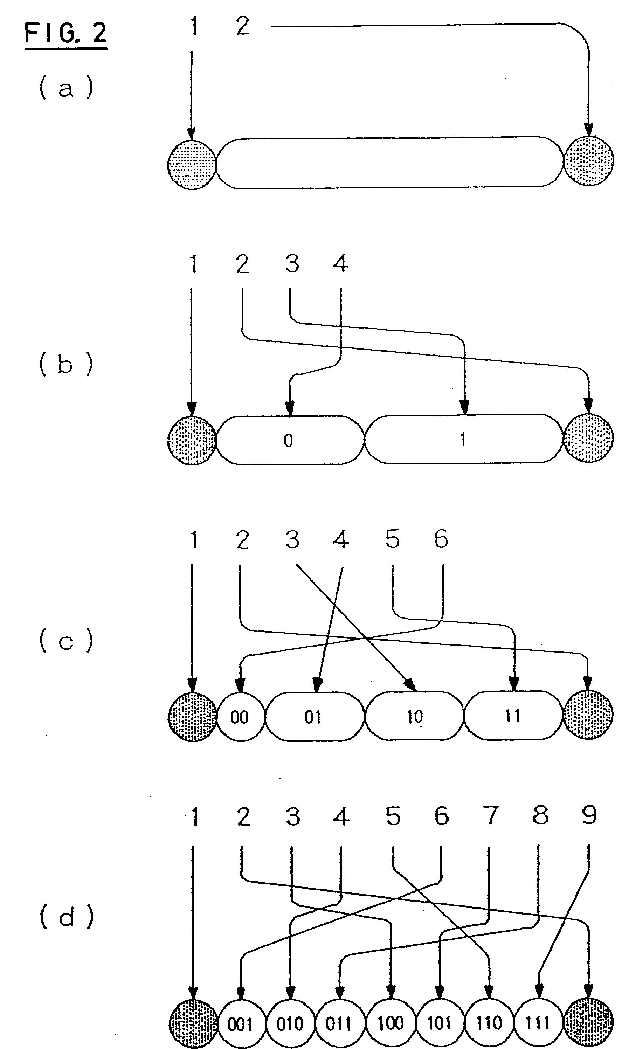

The above discussion is next explained with reference to the example shown in Figure 2, where nine holes are to be made. First, as shown by the black circles in (a) of Figure 2, the holes at both ends are made first and second. In Figure 2, the ellipse represents a series of continuously integrated holes, and the binary numerals in the ellipse indicate their positions. That is, "0" denotes the group located at the left side and consisting of number 2, 3 and 4 while "1" denotes the group located at the right side and consisting of number 5, 6, 7 and 8. Group "0" is divided into "00" and "01."

$T_l$, a partial matrix of the conversion matrix T, is regular by definition, and the vector v has a one-to-one correspondence with the vector u. Therefore, the third and fourth drillings correspond to group "0" and group "1" and to group "1" and group "0" respectively, as shown in (b) of Figure 2. Thus, the holes made third and fourth are dispersed. Next, $T_2$ that is the second partial matrix of T, is also regular; therefore, the 3rd, 4th, 5th and 6th drillings correspond one-to-one to groups "00," "01", "10" and "11," as shown in (c) of Figure 2. That is, the fifth and sixth drillings are also made in a dispersed manner subsequent to the third and fourth drillings. Last, T3 is also regular; therefore, the 3rd, 4th, 5th, 6th, 7th, 8th and 9th drillings correspond one-to-one to groups "001," "010," "011," "100," "101," "110" and "111" as shown in (d) of Figure 2. It will be understood from the above that the holes are made in a dispersed manner according to the present invention.

## Brief Description of the Drawings

Figure 1 is schematics explaining how step drilling works;
Figure 2 is diagrams explaining the theoretical basis of the invention;
Figure 3 is a block diagram showing the entire constitution of one embodiment of the invention;
Figure 4 is a flow chart explaining the operation of the major parts of Figure 3.
Figure 5 is a drawing explaining the major parts of Figure 4;
Figure 6 is a drawing explaining the operation of Figure 5; and
Figure 7 is a drawing explaining the operation of Figure 5.

## Detailed Description of the Invention

An embodiment of the present invention is explained below.

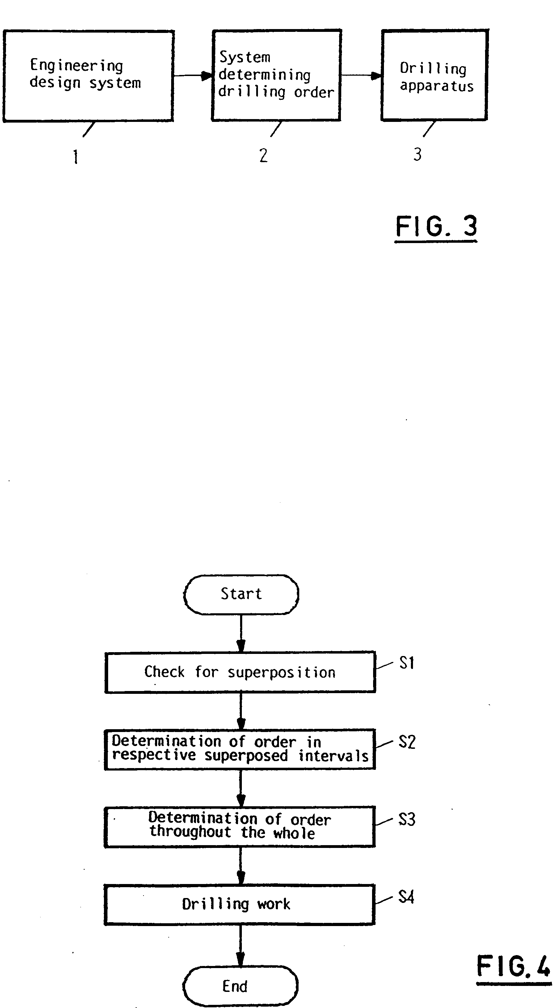

Referring to Figure 3, format information on the drillings generated by an engineering design system 1 is fed to a drilling order determination system 2. The latter system 2 is, for example, an IBM RS/6000 (trademark) workstation. The drilling order determination system 2 feeds information on the drilling order to a drilling machine 3 that drills a plate such as a printed wiring board based on the information.

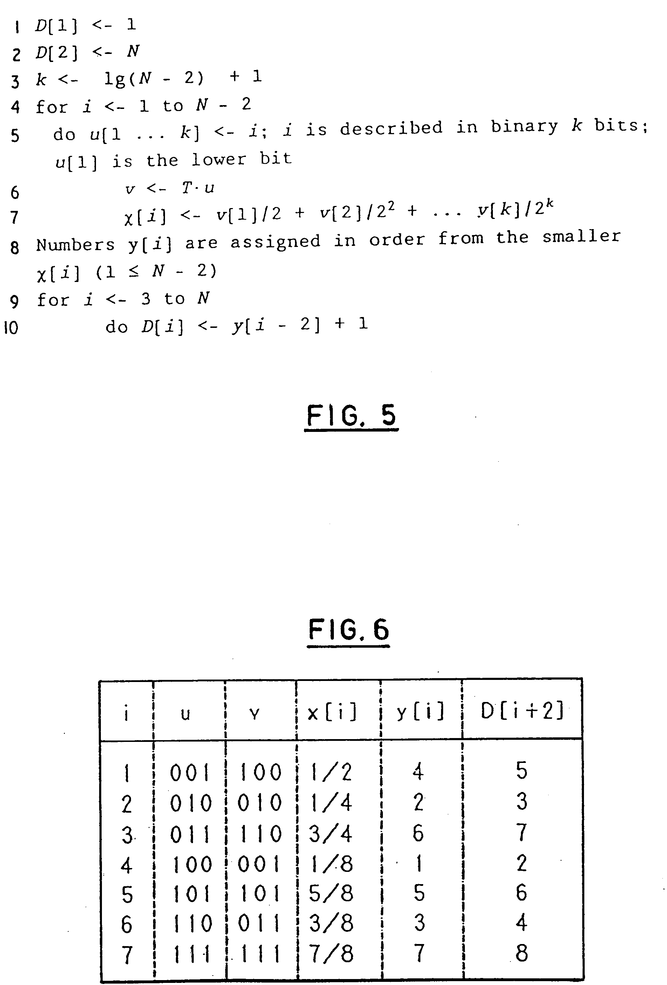

The drilling order determination system operates as shown in Figure 4. As shown, every hole is checked as to whether it is connected to other holes or not (S1). The checking is made through the determination of whether the centre of another hole is located within the hole (circle) in question or not. Once the sequence of the overlapping holes has been determined, the order of the drillings in respective intervals is decided for respective concatenation (S2). This step will be explained in more detail later with reference to Figure 5. Thereafter, the order throughout the whole is decided (S3). The algorithm for solving the "travelling salesman problem" may be employed, for example. The data for the order obtained in this way are supplied to the drill apparatus 3 which makes holes successively.

Next, the determination of the order in the concatenated interval in step S2 is explained with reference to Figure 5. The hole at one end, the left end for example, is taken as the No. 1 hole, while the hole at the other end (right end) is taken as the No. N hole. In Line $l_1$, the first hole to be made, of which the hole number is D[1], is taken as the No. 1 hole. Next in Line $l_2$, the Nth hole to be made, of which the hole number is D[2], is taken as the No. N hole. Then the holes to be made third and thereafter are selected from the holes that are to be located between the left and right holes. The order is first described in binary expression (since the order positions in question are No. 3 and thereafter, the original order position number of No. 3 and thereafter are now replaced by new order position numbers that begin with No. 1: if the original order position inclusive of both end holes is i', then the new order position i = i'- 2 ). For this purpose, the number of bits required should first be calculated. That is, in Line $l_3$, the bit number k is decided on. In Figure 5, $l_g$ denotes log 2 while [] denotes the integer part.

Next, in Line $l_4$, the procedures for the order i = 1 through N - 2 are repeated, where the binary description in k bits is obtained for the order i first. Then the description is expressed as a vector (Line $l_5$). The vector u, which represents the order of drilling is multiplied by the conversion matrix T to get the vector v that represents the hole number (Line $l_6$). The conversion matrix T is, for example, a unit matrix. The value x of the number vector v is then obtained (Line $l_7$). A new number y is given in the order of increasing value of x (Line $l_8$). The order of drilling D [i+2], which equals [i'], is determined on the basis of y (Lines $l_9$ and $l_{10}$). Here, y is a number that represents the relative positions of the holes, for example, 1, 2, 3, ----- from the left. Since there is a No. 1 hole that corresponds to D [1], the result is that D [i + 2] = y [i] + 1.

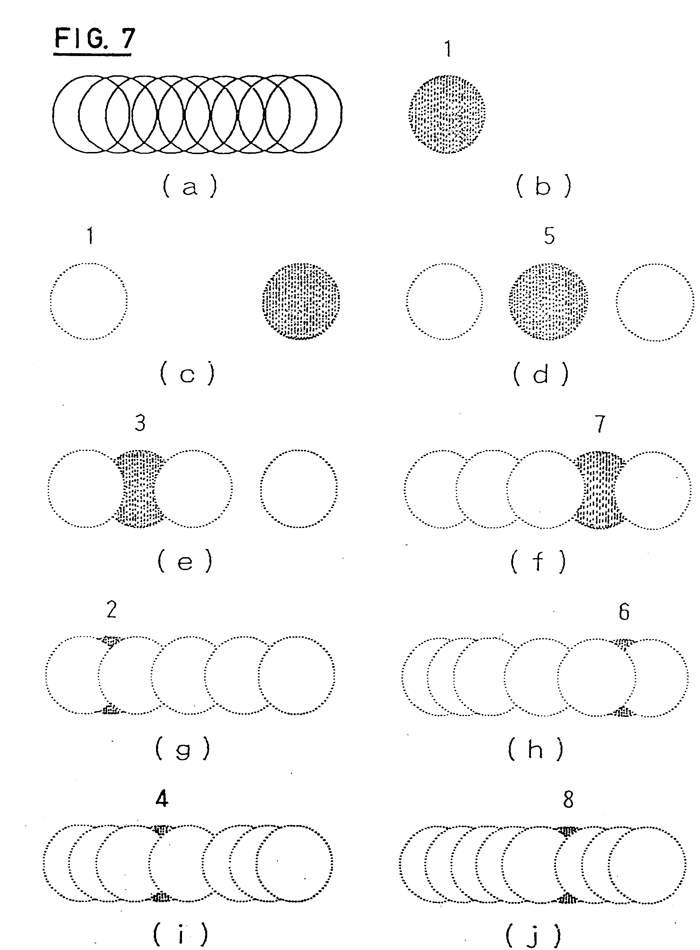

Figure 6 shows values of u, v, x, y and D when the above-mentioned procedures are applied in the case of N = 9. In this embodiment, the drilling is made in the sequence of Nos. 1, 9, 5, 3, 7, 2, 6, 4, and 8, as shown in Figure 7. It is now clear that every hole is drilled under such conditions that the drill screw receives uniform stress at the left and right sides.

Although the embodiment explained hereinabove is for the case of drilling along a straight line, it is clear that the present invention can be applied in cases where holes are to be made along a curve and where uniform drilling is required in a two-dimensional area. In the latter cases, for example, the drilling order in the vertical direction can be determined, and a series of holes drilled in this order in the horizontal direction successively, while the order of horizontal drilling is according to the present invention.

## Claims

1. A drill apparatus for drilling a plurality of holes in a printed circuit board, said holes being concatenated along a line so that a drill screw receives uniform stress along said line, comprising:
   means for determining a plurality of concatenated holes to be made along a line;
   means for determining one hole at one end;
   means for determining another hole at the other end;
   means for describing in a binary vector fashion the order of holes between said one hole and said other hole to be made;
   means for converting binary vectors indicative of said order by a conversion matrix where every partial matrix is normal, and for obtaining binary vectors indicative of positions of said holes; and
   means for driving said drill screw in an order determined on the basis of said binary vectors indicative of said order and said position.

2. A drill apparatus for drilling a plurality of holes in a printed circuit board, said holes being concatenated along a line so that a drill screw receives uniform stress along said line, comprising:
   means for determining a plurality of concatenated holes to be made along a line;
   means for determining one hole at one end;
   means for determining another hole at the other end;
   means for describing in a binary vector fashion the positions of holes between said one hole and said other hole to be made;
   means for converting binary vectors indicative of said positions by a conversion matrix where every partial matrix is normal, and for obtaining binary vectors indicative of order of said holes; and
   means for driving said drill screw in an order determined on the basis of said binary vectors indicative of said position and indicative of said order.

3. A drill apparatus according to Claim 1 or 2, wherein said line is a straight line.

4. A drill apparatus according to Claim 1 or 2, wherein said line is a curve.

5. A drill apparatus according to any one of Claims 1 through 4, wherein said conversion matrix is a unit matrix.

6. A drill apparatus according to any of Claims 1 to 5 further comprising:
   means for generating data defining the hole arrangement.

7. A method for drilling a plurality of holes in a printed circuit board, said holes being concatenated along a line so that a drill screw receives uniform stress along said line, comprising the steps of:
   determining a plurality of concatenated holes to be made along a line;
   determining one hole at one end;
   determining another hole at the other end;
   describing in a binary vector fashion the order of holes between said one hole and said other hole to be made;
   converting binary vectors indicative of said order by a conversion matrix where every partial matrix is normal, and for obtaining binary vectors indicative of positions of said holes; and
   driving said drill screw in an order determined on the basis of said binary vectors indicative of said order and said position.

( a )

( b )

( c )

( d )

( e )

## FIG. 1

# FIG. 2

(a)

(b)

(c)

(d)

| Engineering design system | → | System determining drilling order | → | Drilling apparatus |

1        2        3

## FIG. 3

```
        ( Start )
            │
            ▼
┌─────────────────────────┐
│  Check for superposition │── S1
└─────────────────────────┘
            │
            ▼
┌─────────────────────────────────┐
│ Determination of order in        │── S2
│ respective superposed intervals  │
└─────────────────────────────────┘
            │
            ▼
┌─────────────────────────────────┐
│ Determination of order           │── S3
│   throughout the whole           │
└─────────────────────────────────┘
            │
            ▼
┌─────────────────────────────────┐
│       Drilling work              │── S4
└─────────────────────────────────┘
            │
            ▼
         ( End )
```

## FIG. 4

8

```
 D[1] <- 1
 D[2] <- N
 k <-  lg(N - 2)  + 1
 for i <- 1 to N - 2
   do u[1 ... k] <- i; i is described in binary k bits;
   u[1] is the lower bit
         v <- T·u
         χ[i] <- v[1]/2 + v[2]/2² + ... v[k]/2ᵏ
 Numbers y[i] are assigned in order from the smaller
   χ[i] (1 ≤ N - 2)
 for i <- 3 to N
         do D[i] <- y[i - 2] + 1
```

Line 7 equation:

$$\chi[i] \leftarrow v[1]/2 + v[2]/2^2 + \ldots v[k]/2^k$$

## FIG. 5

## FIG. 6

| i | u | v | x[i] | y[i] | D[i+2] |
|---|-----|-----|------|------|--------|
| 1 | 001 | 100 | 1/2  | 4    | 5 |
| 2 | 010 | 010 | 1/4  | 2    | 3 |
| 3 | 011 | 110 | 3/4  | 6    | 7 |
| 4 | 100 | 001 | 1/8  | 1    | 2 |
| 5 | 101 | 101 | 5/8  | 5    | 6 |
| 6 | 110 | 011 | 3/8  | 3    | 4 |
| 7 | 111 | 111 | 7/8  | 7    | 8 |

# FIG. 7

(a)   (b)

(c)   (d)

(e)   (f)

(g)   (h)

(i)   (j)

**European Patent Office**

## EUROPEAN SEARCH REPORT

Application Number

EP 94 30 6481

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | DE-C-319 489 (SIEMENS-SCHUCKERTWERKE) <br> * page 1, line 53 - line 62; figure 1 * <br> --- | 1-3,7 | B23B35/00 <br> H05K3/00 |
| X | PRINTED CIRCUIT FABRICATION, <br> vol.15, no.10, October 1992, SAN FRANCISCO CA US <br> pages 40 - 41, XP311270 <br> SCHAEFER & ELLETT 'Slot Drilling : Eliminating the Trade-offs' <br> --- | 1-4,7 | |
| A | FR-A-889 063 (SOMBORN) <br> --- | | |
| A | PATENT ABSTRACTS OF JAPAN <br> vol. 9, no. 303 (M-434) (2026) 30 November 1985 <br> & JP-A-60 141 411 (HITACHI) 26 July 1985 <br> * abstract * <br> ----- | | |
| | | | **TECHNICAL FIELDS SEARCHED** (Int.Cl.6) |
| | | | B23B <br> H05K |

The present search report has been drawn up for all claims

| Place of search | Date of completion of the search | Examiner |
|---|---|---|
| THE HAGUE | 14 December 1994 | Bogaert, F |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)